Europäisches Patentamt

European Patent Office

Office européen des brevets

(19)

(11) Numéro de publication : **0 486 406 A1**

# (12) DEMANDE DE BREVET EUROPEEN

(21) Numéro de dépôt : **91420395.5**

(22) Date de dépôt : **06.11.91**

(51) Int. Cl.⁵ : **H05K 7/20**, H05K 7/14

(30) Priorité : **14.11.90 FR 9014243**

(43) Date de publication de la demande :
**20.05.92 Bulletin 92/21**

(84) Etats contractants désignés :
**BE CH DE ES GB IT LI SE**

(71) Demandeur : **MERLIN GERIN**
**2, chemin des Sources**
**F-38240 Meylan (FR)**

(72) Inventeur : **Le Boennec, André**
**MERLIN GERIN - Sce. Brevets**
**F-38050 Grenoble Cedex (FR)**
Inventeur : **Jean, Robert**
**MERLIN GERIN - Sce. Brevets**
**F-38050 Grenoble Cedex (FR)**
Inventeur : **Dalban, Bernard**
**MERLIN GERIN - Sce. Brevets**
**F-38050 Grenoble Cedex (FR)**

(74) Mandataire : **Kern, Paul et al**
**Merlin Gerin Sce. Brevets**
**F-38050 Grenoble Cédex 9 (FR)**

(54) **Boîtier de protection d'un automate industriel.**

(57)   Un automate (10) est fixé à l'intérieur d'un boîtier (11) de protection, par l'intermédiaire d'amortisseurs (22), en ménageant un intervalle d'air (12). Le boîtier étanche (11) assure une protection mécanique et électrique de l'automate (10), et un ventilateur (32) logé dans le boîtier (11) provoque une circulation d'air favorisant le refroidissement de l'automate (10). Des connecteurs agencés en filtres électriques sont fixés sur la paroi du boîtier étanche (11).

FIG.2

EP 0 486 406 A1

L'invention est relative à un boîtier de protection d'un appareil électronique en particulier d'un automate de commande d'un processus industriel ou d'un automate à bord d'un navire, ou d'un véhicule terrestre contre les chocs, les parasites extérieurs et l'échauffement, comprenant une enveloppe étanche métallique à l'intérieur de laquelle est fixé par des amortisseurs mécaniques ledit automate, en ménageant un intervalle d'isolation entre le boîtier et l'automate.

L'invention est basée sur la constatation qu'il existe aujourd'hui des gammes de produits spécifiquement conçus pour une utilisation en milieu industriel et d'autres produits dédiés aux conditions ambiantes exceptionnelles, telles qu'à bord de véhicules militaires terrestres ou navals.

Les appareils standards sont incapables de fonctionner correctement quand ils sont soumis à des chocs et des vibrations mécaniques, ainsi qu'à une pollution par des poussières qui détruisent ou détériorent rapidement les composants électroniques. Les parasites électromagnétiques engendrés par les appareils électriques voisins, ou par le réseau, perturbent également le bon fonctionnement des appareils électroniques. D'autre part, les matériels dédiés sont souvent d'un coût trop élevé pour des applications non vitales.

En disposant l'appareil électronique ou l'automate industriel dans un coffret métallique étanche, il est possible de s'affranchir des chocs et des poussières, et partiellement de l'influence des champs magnétiques et électromagnétiques ambiants, mais le refroidissement de l'appareil est entravé par ce coffret étanche.

La présente invention a pour but de réaliser un boîtier de protection, particulièrement simple et efficace, permettant l'utilisation d'un appareil électronique standard en un milieu perturbé, notamment en un milieu industriel.

Le boîtier de protection selon l'invention est caractérisé en ce qu'un ventilateur, disposé dans le boîtier étanche, provoque une circulation de l'air dans ledit intervalle à l'intérieur du boîtier pour uniformiser la température dans ce dernier, et améliorer le refroidissement par l'enveloppe métallique externe.

La circulation d'air induite par le ventilateur dans l'intervalle d'isolation entre l'appareil électronique, appelé automate par la suite, et le boîtier favorise un refroidissement par convection de l'automate, la chaleur étant transmise à l'enveloppe métallique du boîtier, qui transmet cette chaleur au milieu ambiant.

La circulation interne de l'air n'affecte pas l'étanchéité du boîtier et favorise l'homogénéité de la température de l'automate.

Le boîtier comporte avantageusement des connecteurs des câbles d'entrée et de sortie de l'automate, qui sont agencés en traversées étanches et en filtres électriques empêchant la transmission des perturbations et parasites à l'intérieur du boîtier. L'enveloppe métallique et les connecteurs filtres assurent la compatibilité électromagnétique et permettent l'utilisation de l'automate en des milieux électriquement perturbés.

Il est avantageux de fixer l'automate standard à un berceau de support, par exemple métallique, auquel est assujetti rigidement le ou les ventilateurs de circulation interne d'air. Le berceau est lui-même fixé au boîtier par des amortisseurs en ménageant un intervalle d'air sur l'ensemble du pourtour de l'automate, qui empêche tout contact mécanique avec la paroi du boîtier. Pour des raisons d'encombrement, la forme du boîtier de protection correspond sensiblement à celle de l'automate, mais il est clair qu'un boîtier peut être conçu pour une gamme d'automates de tailles différentes, le volume étant dans certains cas surabondant. L'une des faces du boîtier, généralement de forme parallélépipèdique, est agencée en couvercle démontable qui donne accès, après enlèvement, aux boulons de fixation des amortisseurs et aux connecteurs de la filerie, pour permettre une déconnexion mécanique et électrique de l'automate et une extraction de ce dernier.

D'autres avantages et caractéristiques ressortiront plus clairement de la description qui va suivre, d'un mode de mise en oeuvre de l'invention, donné à titre d'exemple non limitatif et représenté aux dessins annexés dans lesquels:

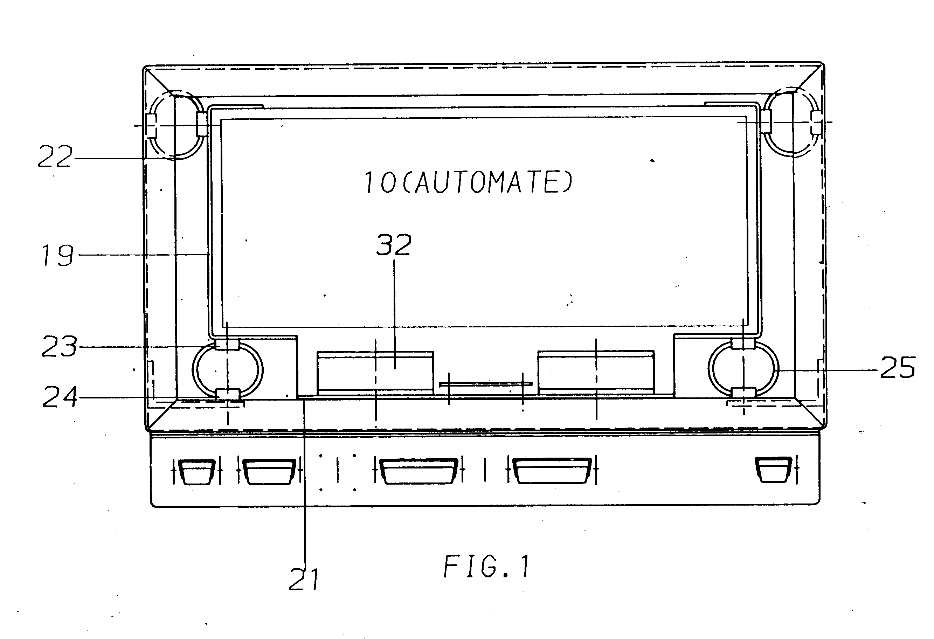

La figure 1 est une vue schématique en plan d'un boîtier de protection selon l'invention, le couvercle étant supposé enlevé;

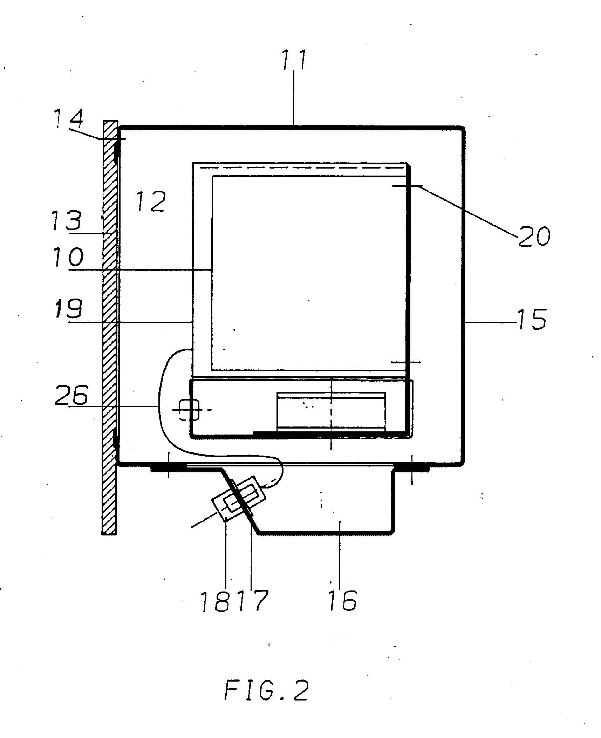

La figure 2 est une vue de côté du boîtier selon la figure 1, la paroi latérale étant supposée enlevée.

Sur les figures, un automate 10, représenté par son contour externe parallélépipèdique, est logé à l'intérieur d'un boîtier 11 de forme conjuguée. Les dimensions du boîtier 11 sont supérieures à celles de l'automate 10, de façon à ménager sur toutes les faces, un intervalle 12 évitant tout contact mécanique entre l'automate 10 et le boîtier 11. Le boîtier 11 en tôle est obturé d'une manière étanche à sa face supérieure par une plaque métallique 13, fixée par des boulons 14, pour constituer un couvercle donnant accès à l'intérieur d'un boîtier après enlèvement. Le fond opposé 15 peut également être agencé en plaque amovible constituant l'embase de fixation du boîtier. La face avant du boîtier 11 présente un appendice 16 ayant une face inclinée 17 portant des connecteurs 18.

L'automate 10 est rigidement assujetti par des boulons 20 à un berceau 19, réalisé par des profilés ou des tôles encadrant à faible jeu l'automate 10 sur l'ensemble de ces faces, sauf celle en regard du couvercle 13. Le berceau 19 est prolongé du côté de la face avant par un support 21 de deux ventilateurs 32. Le berceau 19 est lui-même fixé à l'enveloppe du boîtier 11 par des amortisseurs 22 constitués de deux plaques de fixation 23,24, reliées par des tresses élastiques 25. Les amortisseurs 22 peuvent bien entendu être d'un type quelconque, leur disposition et leur nombre étant suffisants pour positionner élastiquement l'ensemble à l'intérieur du boîtier 11 en évitant tout contact mécanique entre l'automate 10 et le boîtier 11, et en amortissant les chocs et les vibrations susceptibles d'être transmis par le boîtier 11 à l'automate 10. L'emploi d'un berceau 19 permet une disposition appropriée des amortisseurs 22, cette disposition étant totalement indépendante des moyens standards de fixation de l'automate 10. L'ensemble automate 10, berceau 19 et ventilateur 32 constitue un ensemble ou bloc susceptible d'être extrait du boîtier 11 après enlèvement du couvercle 13 et déconnexion des amortisseurs 22. Les connecteurs 18 sont reliés par une filerie 26 au bornier (non représenté) de l'automate 10, et cette filerie doit bien entendu également être déconnectée lors d'une séparation de l'automate 10 du boîtier 11. Les connecteurs 18 qui sont des entrées et sorties de l'automate, ainsi que les alimentations de ce dernier sont, si nécessaire, agencées en filtres électriques, bien connus en soi, empêchant toute transmission de parasites vers l'automate 10 ou inversement vers l'extérieur.

L'automate 10 est séparé du boîtier 11 par l'intervalle d'air 12, et les seules connexions par les amortisseurs 22 et la filerie 26 sont incapables de transmettre à l'automate 10 des chocs ou autres perturbations nuisibles. Le ou les ventilateurs 32 assurent une circulation d'air à l'intérieur du boîtier 11, notamment dans l'intervalle 12 qui assure une uniformisation de la température à l'intérieur du boîtier 11, et une circulation entre l'automate 10, ou plus particulièrement les parties chaudes de l'automate 10, et l'enveloppe métallique du boîtier 11. Cette circulation d'air évite que l'intervalle 12 constitue une isolation thermique empêchant un refroidissement efficace de l'automate 10. Ce refroidissement est réalisé sans solution de continuité de l'étanchéité du boîtier 11, ce qui évite tout risque d'accès de parasites ou de pollution vers l'automate 10. Le degré de protection peut être adapté aux conditions d'utilisation, mais en tous les cas, les moyens de mise en oeuvre sont simples et peu coûteux.

Il est clair que le ventilateur 32 peut également être fixé à l'enveloppe du boîtier 11, ou que le berceau 19 peut être simplifié et être agencé en simple cadre s'étendant entre les points de fixations des amortisseurs 22 et ceux de l'automate 10. Le boîtier selon l'invention présente l'avantage d'être adaptable à tous type d'appareils électroniques ou automates, et d'être utilisable le cas échéant avec une gamme d'appareils dont les formes ne sont pas obligatoirement parallélépipèdiques.

L'invention est bien entendu nullement limitée au mode de mise en oeuvre plus particulièrement décrit.

## Revendications

1. Boîtier de protection d'un appareil électronique en particulier d'un automate (10) de commande d'un processus industriel ou d'un automate à bord d'un navire ou d'un véhicule terrestre, contre les chocs, les parasites extérieures et l'échauffement, comprenant une enveloppe étanche métallique à l'intérieur de laquelle est fixé par des amortisseurs mécaniques (22) ledit automate (10), en ménageant un intervalle (12) d'isolation entre le boîtier (11) et l'automate (10), caractérisé en ce qu'un ventilateur (32), disposé dans le boîtier étanche (11), provoque une circulation de l'air dans ledit intervalle (12) à l'intérieur du boîtier (11) pour uniformiser la température dans ce dernier et améliorer le refroidissement par l'enveloppe métallique externe.

2. Boîtier de protection selon la revendication 1, caractérisé en ce que ladite enveloppe porte des connecteurs (18) des câbles d'entrée et de sortie de l'automate (10), agencés en traversées étanches et en filtres électriques pour assurer avec l'enveloppe métallique la compatibilité électromagnétique.

3. Boîtier de protection selon la revendication 1 ou 2, caractérisé en ce que l'automate (10) est rigidement fixé à un berceau de support (19) qui porte également ledit ventilateur (32) et que lesdits amortisseurs (23) sont montés entre le boîtier (11) et le berceau (19).

4. Boîtier de protection selon la revendication 1,2 ou 3, caractérisé en ce que le boîtier (11) de forme générale parallélépipèdique comporte une face agencée en couvercle (13), dont l'ouverture donne accès aux boulons de fixation du berceau (19) et à la filerie (26) de connexion pour permettre l'extraction de l'automate avec son berceau.

FIG.1

10(AUTOMATE)

FIG.2

EP 0 486 406 A1

Office européen
des brevets

**RAPPORT DE RECHERCHE EUROPEENNE**

Numero de la demande

EP 91 42 0395

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.5) |
|---|---|---|---|
| Y | WO-A-8 702 214 (WISTLING)<br>* le document en entier *<br>--- | 1-2 | H05K7/20<br>H05K7/14 |
| Y | US-A-4 956 750 (MAGGELET)<br>* le document en entier *<br>--- | 1-2 | |
| A | FR-A-2 284 247 (SIEMENS)<br>* le document en entier *<br><br>----- | 3,4 | |

|  | DOMAINES TECHNIQUES RECHERCHES (Int. Cl.5) |
|---|---|
|  | H05K |

Le présent rapport a été établi pour toutes les revendications

| Lieu de la recherche | Date d'achèvement de la recherche | Examinateur |
|---|---|---|
| LA HAYE | 07 JANVIER 1992 | TOUSSAINT |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P0402)

6